## Europäisches Patentamt

## European Patent Office

## Office européen des brevets

(19)

(11) EP 0 587 509 B1

(12) # FASCICULE DE BREVET EUROPEEN

(45) Date de publication et mention
de la délivrance du brevet:
**25.03.1998 Bulletin 1998/13**

(51) Int Cl.⁶: **H03F 3/45**, G05F 1/56

(21) Numéro de dépôt: **93420355.5**

(22) Date de dépôt: **01.09.1993**

(54) **Circuit convertisseur tension/courant**

Spannungs-Strom-Umsetzerschaltungsanordnung

Voltage-current converter circuit

(84) Etats contractants désignés:
**DE FR GB IT**

(30) Priorité: **07.09.1992 FR 9211061**

(43) Date de publication de la demande:
**16.03.1994 Bulletin 1994/11**

(73) Titulaire: **SGS-THOMSON MICROELECTRONICS S.A.**
**94250 Gentilly (FR)**

(72) Inventeur: **Barou, Michel**
**F-38340 Voreppe (FR)**

(74) Mandataire: **de Beaumont, Michel**
**1bis, rue Champollion**
**38000 Grenoble (FR)**

(56) Documents cités:
**EP-A- 0 355 906**     **GB-A- 2 223 902**
**US-A- 4 667 166**     **US-A- 4 748 420**
**US-A- 4 774 476**

## Description

La présente invention concerne un circuit permettant d'obtenir un courant proportionnel à une tension d'entrée, et plus particulièrement un tel circuit simplement réalisable sous forme de circuit intégré.

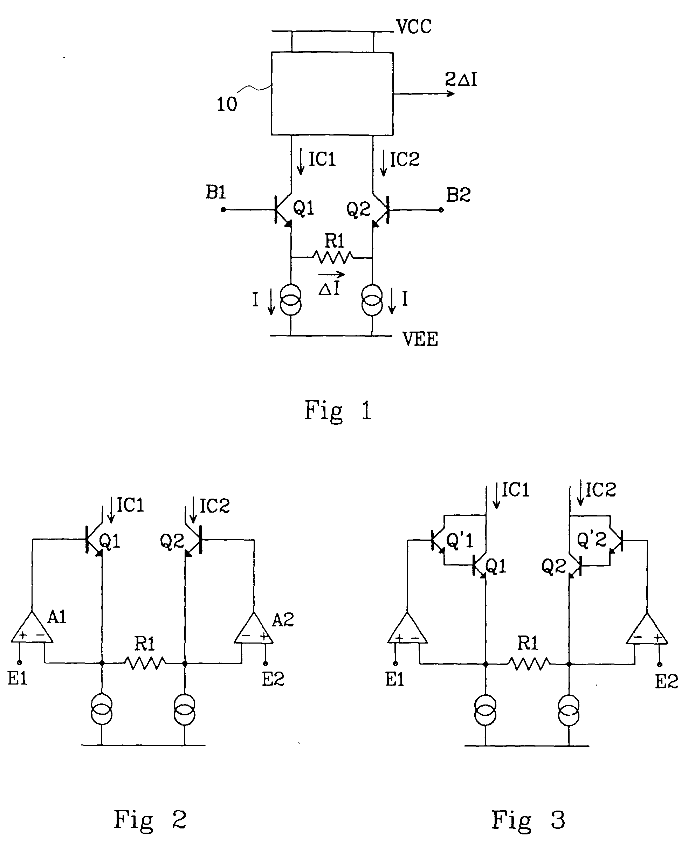

La figure 1 représente un schéma classiquement utilisé pour une conversion tension/courant. Ce circuit comprend deux transistors bipolaires de type NPN Q1 et Q2 dont les collecteurs sont reliés à une tension haute VCC et dont les émetteurs sont connectés à une tension basse VEE par l'intermédiaire de sources de courant I. Les émetteurs sont interconnectés par une résistance R1. Les courants de collecteur de ces transistors sont appelés IC1 et IC2. La tension Ve à convertir en courant est appliquée entre les bases B1 et B2 des transistors Q1 et Q2. Ainsi, la tension aux bornes de R1, V(R1) est :

$$V(R1) = Ve + (Vbe2-Vbe1).$$

Le courant $\Delta I$ dans la résistance R1 est $\Delta I = V(R1)/R1$. Le courant d'émetteur de Q1 est $I+\Delta I$ et celui de Q2 est $I-\Delta I$. Si l'on admet que les chutes de tension base-émetteur Vbe1 et Vbe2 des transistors Q1 et Q2 sont égales, et que la différence des courants d'émetteur se retrouve dans la différence des courants de collecteur, on a $IC1 - IC2 = 2\Delta I = 2Ve/R1$.

Un circuit classique 10, par exemple du type à miroir de courant, permet de fournir la différence entre les courants IC1 et IC2 et fournit en sortie le courant $2\Delta I$ proportionnel à Ve.

Dans ce qui précède, on a fait deux hypothèses simplificatrices. La première est que Vbe1=Vbe2, la deuxième est que la différence des courants d'émetteur se retrouve dans la différence des courants de collecteur. En fait, les courants de collecteur des transistors Q1 et Q2 sont $IC1=\alpha(I+\Delta I)$ et $IC2=\alpha(I-\Delta I)$ où $\alpha$ est le gain en courant en base commune des transistors Q1 et Q2 (on suppose que ces deux transistors ont le même gain.) $\alpha$ s'exprime en fonction du coefficient d'amplification de courant en émetteur commun, $\beta$, des transistors Q1 et Q2 par la relation $\alpha = 1/(1+1/\beta)$. Ainsi, le courant $\Delta I$, au lieu d'être simplement égal à Ve/R1 s'exprime en fait par la relation :

$$\Delta I = \alpha[Ve + (Vbe2-Vbe1)]/R1.$$

Ainsi, une première erreur résulte de la valeur de Vbe2-Vbe1 qui est non nulle et varie avec le courant et la température. La deuxième erreur résulte du fait que $\alpha$ n'est pas égal à 1, et peut être non négligeable dans le cas où $\beta$ est relativement faible. Par exemple, si $\beta = 35$, $\alpha$ est égal à 0,97 et on a une erreur de proportionnalité de l'ordre de 3 %.

Une façon classique de corriger la première erreur est illustrée en figure 2. Une contre-réaction est imposée entre l'émetteur et la base de chacun des transistors Q1 et Q2 par des amplificateurs différentiels A1 et A2 dont les sorties sont respectivement appliquées aux bases des transistors Q1 et Q2 et dont les entrées inverseuses sont respectivement connectées aux émetteurs des transistors Q1 et Q2. Le signal d'entrée est appliqué entre les entrées non-inverseuses E1 et E2 des amplificateurs A1 et A2. Ainsi, l'erreur liée à la valeur non nulle de Vbe2-Vbe1 est atténuée d'un facteur AV, où AV est le gain en tension de chacun des amplificateurs A. Ce gain peut être très élevé, par exemple supérieur à 100 et la petite erreur sur la différence des tensions base-émetteur devient ainsi une erreur du second ordre bien inférieure à 1/1000.

Une façon classique de corriger la deuxième erreur consiste à remplacer chacun des transistors Q1 et Q2 par un montage de type Darlington. Comme cela est représenté en figure 3, chacun des transistors Q1 et Q2 est associé en un montage Darlington avec un transistor respectif Q'1 et Q'2. Si l'on considère que les transistors Q1, Q2, Q'1 et Q'2 ont le même coefficient d'amplification de courant en émetteur commun, $\beta$, les coefficients d'amplification de courant en base commune $\alpha$ deviennent $1[1+1/\beta(\beta+1)]$, A nouveau, on transforme une erreur du premier ordre en erreur du second ordre qui devient négligeable.

Ainsi, le circuit de la figure 3 qui combine les moyens de correction du premier et du deuxième type d'erreur donne satisfaction et l'on a bien des courants IC1 et IC2 dont la différence est proportionnelle (le coefficient de proportionnalité étant lié à la valeur de la résistance R1) à la différence de tension entre les bornes E1 et E2.

Toutefois, ce circuit présente un inconvénient lié à la présence d'un montage de type Darlington. En effet, quand on considère un transistor isolé tel que le transistor Q1 ou Q2, sa chute de tension collecteur/émetteur à l'état passant, Vsat, est de l'ordre de 0,2 volt. Alors que, dans le cas d'un montage Darlington, cette chute de tension est augmentée de la valeur moyenne d'une chute de tension base-émetteur, c'est-à-dire que la chute de tension totale se rapproche d'une valeur de l'ordre du volt. Ce phénomène s'aggrave à basse température où Vbe augmente. Cette chute de tension relativement importante aux bornes des transistors constitue un inconvénient notamment du fait que, comme cela est illustré en figure 1, d'autres étages à transistors existent entre la borne d'alimentation haute et la borne d'alimentation basse (entre VCC et VEE). Ceci impose que la différence VCC - VEE doit être plus élevée dans le cas du montage de la figure 3 que dans le cas du montage de la figure 1 et interdit l'utilisation du circuit de la figure 3 dans le cas où cette différence de tension (tension d'alimentation) est faible.

Un objet de la présente invention est de prévoir un circuit de conversion d'une tension en courant dans lequel la chute de tension aux bornes des éléments de production du courant soit aussi faible que possible.

Pour atteindre cet objet, la présente invention prévoit un circuit de conversion d'une tension en une différence de courant, comprenant une première paire différentielle comprenant un premier et un deuxième transistor NPN dont les émetteurs sont reliés à une borne d'alimentation basse par l'intermédiaire d'une source de courant et dont les collecteurs sont reliés à une borne d'alimentation haute, une deuxième paire différentielle comprenant un troisième et un quatrième transistors NPN dont les émetteurs sont reliés à une borne d'alimentation basse par l'intermédiaire d'une source de courant et dont les collecteurs sont reliés à une borne d'alimentation haute, une première résistance entre les émetteurs des transistors de la première paire, une deuxième résistance entre les émetteurs des transistors de la deuxième paire, des troisième et quatrième résistances entre les bases des premier et troisième transistors et des deuxième et quatrième transistors respectivement, et un moyen de contre-réaction en tension entre les bornes de la deuxième résistance et les bases des transistors de la première paire pour fixer le potentiel aux bornes de la deuxième résistance à un potentiel d'entrée.

Selon un mode de réalisation de la présente invention, les moyens de contre-réaction comprennent des amplificateurs opérationnels ayant chacun une première entrée reliée à une borne de la deuxième résistance, une deuxième entrée constituant une borne d'entrée et une sortie appliquée à la base d'un transistor de la première paire.

Selon un mode de réalisation de la présente invention, chacun des amplificateurs opérationnels est constitué d'un cinquième transistor NPN et d'un sixième transistor PNP, la base du cinquième transistor étant reliée à une borne de la deuxième résistance, l'émetteur du cinquième transistor étant relié à la borne d'entrée, le collecteur du cinquième transistor étant relié à la borne d'alimentation haute par une source de courant, la base du sixième transistor étant reliée au collecteur du cinquième transistor, l'émetteur du sixième transistor étant relié à la borne d'alimentation haute par l'intermédiaire d'une source courant et à la base d'un transistor de la première paire différentielle, et le collecteur du sixième transistor étant relié à la borne d'alimentation basse.

Selon un mode de réalisation de la présente invention, un amplificateur opérationnel est constitué d'un transistor NPN dont le collecteur est relié à la borne d'alimentation haute par l'intermédiaire d'une source de courant et à la base d'un transistor de la première paire, dont l'émetteur est relié à une deuxième borne d'entrée et dont la base est reliée d'une part à une première borne d'entrée, d'autre part à une borne de la deuxième résistance.

Selon un mode de réalisation de la présente invention, les troisième et quatrième résistances ont une même valeur égale à la moitié de la valeur de la deuxième résistance.

Ces objets, caractéristiques et avantages ainsi que d'autres de la présente invention seront exposés en détail dans la description suivante de modes de réalisation particuliers faite en relation avec les figures jointes parmi lesquelles :

les figures 1 à 3, destinées à illustrer l'état de la technique, ont été décrites précédemment ;
la figure 4 représente un premier mode de réalisation d'un circuit de conversion tension-courant selon la présente invention ;
la figure 5 représente une variante du circuit de la figure 4 ; et
les figures 6 et 7 représentent des réalisations plus détaillées des amplificateurs de contre-réaction utilisés respectivement en figures 4 et 5.

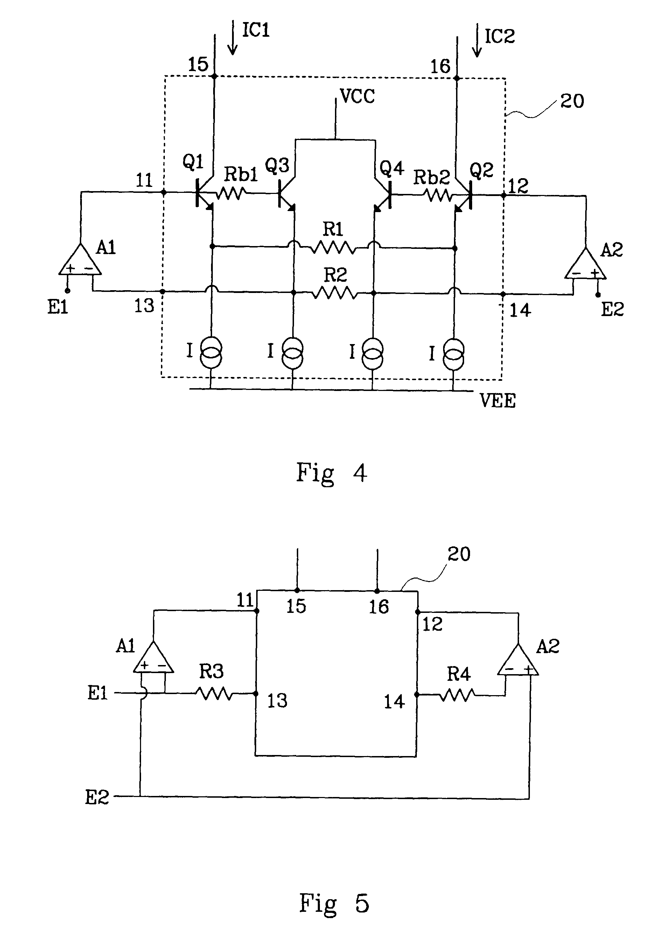

La figure 4 représente un mode de réalisation d'un circuit selon la présente invention. Ce circuit contient une première paire différentielle comprenant des transistors Q1 et Q2 et une deuxième paire différentielle comprenant des transistors Q3 et Q4. Dans le mode de réalisation représenté, tous ces transistors sont de type NPN. Les émetteurs des transistors Q1 à Q4 sont reliés à la borne d'alimentation basse VEE par l'intermédiaire de sources de courant I. Les collecteurs des transistors Q1 à Q4 sont connectés à une borne d'alimentation haute VCC, directement ou indirectement mais en tout cas par des trajets de même impédance pour chacun des transistors d'une paire différentielle. Les émetteurs des transistors Q1 et Q2 sont connectés par l'intermédiaire d'une résistance R1 et les émetteurs du transistor Q3 et Q4 sont connectés par l'intermédiaire d'une résistance R2. Les sorties d'amplificateurs opérationnels A1 et A2 sont respectivement connectées aux bases des transistors Q1 et Q2. Les entrées inverseuses de ces amplificateurs sont respectivement connectées aux émetteurs des transistors Q3 et Q4 et les entrées non-inverseuses E1 et E2 de ces amplificateurs correspondent à des bornes d'entrée entre lesquelles est appliquée la tension que l'on veut convertir en un courant, le courant converti étant proportionnel à la différence entre les courants de collecteur IC1 et IC2 des transistors Q1 et Q2. Les bases des transistors Q1 et Q3 et les bases des transistors Q2 et Q4 sont respectivement reliées par des résistances de liaison Rbl et Rb2 de même valeur, Rb.

Pour la commodité de la description, on désigne par les références 11 et 12 les bornes de base des transistors Q1 et Q2, par 13 et 14 les bornes d'émetteur des transistors Q3 et Q4, et par 15 et 16 des bornes de collecteur des transistors Q1 et Q2. Ces bornes constituent les accès à un bloc encadré de pointillés et désigné par la référence 20 en figure 4.

Dans le cas des figures 2 et 3, du fait de la présence des amplificateurs opérationnels A1 et A2 à fort gain, on retrouvait aux bornes de la résistance R1 la différence de potentiel Ve entre les entrées E1 et E2. De même, dans le cas de la figure 4, on retrouve cette différence de potentiel Ve aux bornes de la résistance R2. Le courant IR2 dans cette résistance est égal à Ve/R2 pratiquement sans erreur ou bien avec une erreur négligeable du deuxième ordre. On retrouve les courants I + IR2 et I - IR2 dans les émetteurs des transistors Q3 et Q4. La tension différentielle entre les bases des transistors Q1 et Q2 est également appliquée de façon différentielle sur les bases des transistors Q3 et Q4 d'où il résulte une différence de tension aux bornes de R1 (en négligeant les erreurs sur les différences de Vbe qui sont, dans ce cas du deuxième ordre) :

$$V(R1) = Ve + 2Rb \cdot IR2/\beta$$

ou

$$V(R1) = Ve \, (1 + 2Rb/\beta R2).$$

La différence de courant de collecteur des transistors Q1 et Q2 est égale au double du courant dans la résistance R1 multiplié par le coefficient de gain $\alpha$ ($\approx$ 1-1/$\beta$). Ainsi, en choisissant Rb = R2/2, on obtient :

$$IC1 - IC2 = (2Ve/R1)(1+1/\beta)(1-1/\beta)$$

soit

$$IC1 - IC2 = (2Ve/R1)(1-1/\beta^2)$$

c'est-à-dire, $\beta^2$ étant négligeable, que cette différence de courant devient sensiblement égale à 2Ve/R1 et que, comme on le souhaite, elle est proportionnelle à la tension Ve. Ce résultat est obtenu alors que la différence de potentiel aux bornes des transistors Q1 et Q2 reste la chute de tension à l'état de conduction d'un transistor bipolaire qui, comme on l'a exposé précédemment, est de l'ordre de 0,2 volt.

Comme dans les circuits de l'art antérieur, le coefficient de proportionnalité entre la tension et le courant ne dépend que de la valeur de la résistance R1. Les valeurs des résistances R2, Rb1 et Rb2 n'interviennent que par leur rapport qui peut être extrêmement précis dans une réalisation sous forme de circuit intégré.

Bien entendu, l'homme de l'art pourra envisager diverses variantes de réalisation du circuit selon la présente invention.

La figure 5 représente une variante dans laquelle le mode de connexion des amplificateurs opérationnels A1 et A2 a été modifié. On retrouve dans cette figure le bloc 20 de la figure 4 avec ses bornes 11 à 16. Cette fois-ci, les entrées inverseuses des amplificateurs opérationnels A1 et A2 sont connectées aux bornes 13 et 14 par l'intermédiaire de résistances respectives R3 et R4 et les entrées non-inverseuses sont interconnectées. Les bornes d'entrée E1 et E2 correspondent alors à l'entrée inverseuse de l'amplificateur A1 et aux entrées non-inverseuses des amplificateurs A1 et A2. Dans ce cas, une tension pourra être appliquée entre les entrées E1 et E2 avec interposition d'une résistance série sur la borne E1 d'une façon connue de l'homme de métier.

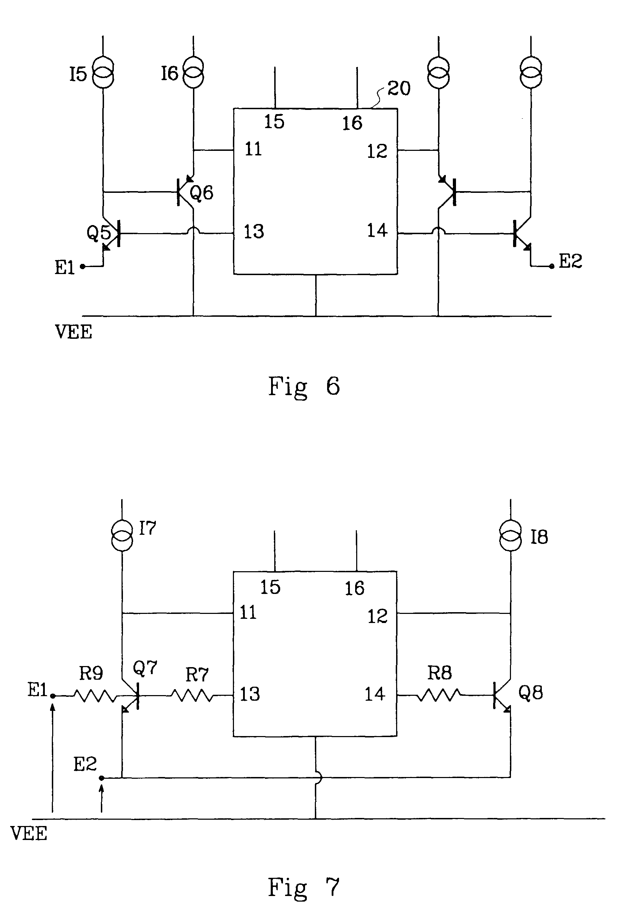

La figure 6 représente un exemple de réalisation des amplificateurs opérationnels dans le cas du montage de la figure 4. Seul l'amplificateur A1 sera décrit en détail, l'amplificateur A2 étant réalisé de façon identique. Cet amplificateur A1 est constitué de deux transistors Q5 et Q6, respectivement de type NPN et PNP. Le collecteur du transistor Q5 est relié à la source d'alimentation haute par une source de courant I5. L'émetteur du transistor Q6 est relié à la borne 11 et à cette borne d'alimentation haute par une source de courant I6. La base du transistor Q6 est reliée au collecteur du transistor Q5. Le collecteur du transistor Q6 est relié à la borne d'alimentation basse VEE. La base du transistor Q5 est reliée à la borne 13. L'émetteur du transistor Q5 correspond à la borne d'entrée E1.

La figure 7 représente un exemple de réalisation des amplificateurs opérationnels A1 et A2 dans le cadre d'un montage du type de celui de la figure 5. Les amplificateurs opérationnels A1 et A2 sont respectivement constitués de transistors NPN Q7 et Q8. Les collecteurs sont respectivement reliés aux bornes 11 et 12 et à la borne d'alimentation haute par l'intermédiaire de sources de courant respectives I7 et I8. Les émetteurs sont interconnectés et constituent la borne d'entrée E2. Les bases des transistors Q7 et Q8 sont respectivement reliées aux bornes 13 et 14 par l'intermédiaire de résistances R7 et R8. Comme on l'a indiqué précédemment, la borne d'entrée EI est de préférence reliée à la base du transistor Q7 par l'intermédiaire d'une résistance R9.

**Revendications**

1.  Circuit de conversion d'une tension en une différence de courant, comprenant :

    une première paire différentielle comprenant un premier (Q1) et un deuxième (Q2) transistor NPN dont les émetteurs sont reliés à une borne d'alimentation basse (VEE) par l'intermédiaire d'une source de courant et dont les collecteurs sont reliés à une borne d'alimentation haute (VCC),
    une deuxième paire différentielle comprenant un troisième (Q3) et un quatrième (Q4) transistors NPN dont les émetteurs sont reliés à une borne d'alimentation basse (VEE) par l'intermédiaire d'une source de courant et dont les collecteurs sont reliés à une borne d'alimentation haute (VCC),
    une première résistance (R1) entre les émetteurs des transistors de la première paire,

une deuxième résistance (R2) entre les émetteurs des transistors de la deuxième paire,
des troisième et quatrième résistances (RB1 et RB2) entre les bases du premier et troisième transistors et des deuxième et quatrième transistors respectivement,
un moyen de contre-réaction en tension (A1, A2) entre les bornes de la deuxième résistance (R2) et les bases des transistors de la première paire pour fixer le potentiel aux bornes de la deuxième résistance à un potentiel d'entrée (E1, E2).

2. Circuit selon la revendication 1, caractérisé en ce que les moyens de contre-réaction comprennent des amplificateurs opérationnels (A1, A2) ayant chacun une première entrée reliée à une borne de la deuxième résistance, une deuxième entrée constituant une borne d'entrée et une sortie appliquée à la base d'un transistor de la première paire.

3. Circuit selon la revendication 2, caractérisé en ce que chacun des amplificateurs opérationnels est constitué d'un cinquième transistor NPN (Q5) et d'un sixième transistor PNP (Q6), la base du cinquième transistor étant reliée à une borne de la deuxième résistance, l'émetteur du cinquième transistor étant relié à la borne d'entrée, le collecteur du cinquième transistor étant relié à la borne d'alimentation haute par une source de courant (I5), la base du sixième transistor étant reliée au collecteur du cinquième transistor, l'émetteur du sixième transistor étant relié à la borne d'alimentation haute par l'intermédiaire d'une source courant (I6) et à la base d'un transistor de la première paire différentielle, et le collecteur du sixième transistor étant relié à la borne d'alimentation basse.

4. Circuit selon la revendication 2, caractérisé en ce qu'un amplificateur opérationnel est constitué d'un transistor NPN (Q7, Q8) dont le collecteur est relié à la borne d'alimentation haute par l'intermédiaire d'une source de courant (I7, I8) et à la base d'un transistor de la première paire, dont l'émetteur est relié à une deuxième borne d'entrée et dont la base est reliée d'une part à une première borne d'entrée, d'autre part à une borne de la deuxième résistance.

5. Circuit selon la revendication 1, caractérisé en ce que les troisième et quatrième résistances ont une même valeur égale à la moitié de la valeur de la deuxième résistance.

**Patentansprüche**

1. Schaltung zur Umwandlung bzw. Umsetzung einer Spannung in eine Stromdifferenz, umfassend:

- ein erstes Differentialpaar, welches einen ersten (Q1) und einen zweiten (Q2) NPN-Transistor umfaßt, deren Emitter über eine Stromquelle mit einem niedrigen Speiseanschluß (VEE) verbunden sind und deren Kollektoren mit einem hohen Speiseanschluß (VCC) verbunden sind,

- ein zweites Differentialpaar aus einem dritten (Q3) und einem vierten (Q4) NPN-Transistor, deren Emitter über eine Stromquelle mit einem niedrigen Speiseanschluß (VEE) und deren Kollektoren mit einem hohen Speiseanschluß (VCC) verbunden sind,

- einen ersten Widerstand (R1) zwischen den Emittern der Transistoren des ersten Paars,

- einen zweiten Widerstand (R2) zwischen den Emittern der Transistoren des zweiten Paars,

- einen dritten und einen vierten Widerstand (RB1 und RB2) zwischen den Basisanschlüssen des ersten und des dritten Transistors bzw. den Basisanschlüssen des zweiten und des vierten Transistors,

- Schaltmittel (A1, A2) zur Spannungs-Gegenkopplung zwischen den Anschlüssen des zweiten Widerstands (R2) und den Basisanschlüssen der Transistoren des ersten Paars, um das Potential an den Anschlüssen des zweiten Widerstands auf ein Eingangspotential (E1, E2) einzustellen.

2. Schaltung nach Anspruch 1, dadurch gekennzeichnet, daß die Gegenkopplungs-Schaltmittel Operationsverstärker (A1, A2) aufweisen, deren jeder jeweils einen mit einem Anschluß des zweiten Transistors verbundenen ersten Eingang, einen einen Eingangsanschluß bildenden zweiten Eingang sowie einen an die Basis eines Transistors des ersten Paars angelegten Ausgang aufweist.

3. Schaltung nach Anspruch 2, dadurch gekennzeichnet, daß jeder der Operationsverstärker jeweils aus einem fünften NPN-Transistor (Q5) und einem sechsten PNP-Transistor (Q6) besteht, wobei die Basis des fünften Transistors mit einem Anschluß des zweiten Widerstands verbunden ist, der Emitter des fünften Transistors mit dem Eingangsanschluß verbunden ist und der Kollektor des fünften Transistors über eine Stromquelle (I5) mit dem hohen Speiseanschluß verbunden ist, und wobei die Basis des sechsten Transistors mit dem Kollektor des fünften Transistors verbunden ist, der Emitter des sechsten Transistors über eine Stromquelle (I6) mit dem hohen Speiseanschluß und mit der Basis eines Transistors des ersten Differentialpaars verbunden ist, und der Kollektor des sechsten Transistors mit dem niedrigen Speiseanschluß verbunden ist.

**4.** Schaltung nach Anspruch 2,
dadurch gekennzeichnet, daß ein Operationsverstärker aus einem NPN-Transistor (Q7, Q8) besteht, dessen Kollektor über eine Stromquelle (I7, I8) mit dem hohen Speiseanschluß und mit der Basis eines Transistors des ersten Paares verbunden ist, dessen Emitter mit einem zweiten Eingangsanschluß verbunden ist und dessen Basis einerseits mit einem ersten Eingangsanschluß und andererseits mit einem Anschluß des zweiten Widerstands verbunden ist.

**5.** Schaltung nach Anspruch 1,
dadurch gekennzeichnet, daß der dritte und der vierte Widerstand gleich groß sind und dem halben Wert des zweiten Widerstands entsprechen.

**Claims**

**1.** A circuit for converting a voltage into a current difference, including:

a first differential pair including a first (Q1) and second (Q2) NPN transistor whose emitters are connected to a low supply terminal (VEE) through a current source and whose collectors are connected to a high supply terminal (VCC), a second differential pair including a third (Q3) and fourth (Q4) NPN transistor whose emitters are connected to a low supply terminal (VEE) through a current source and whose collectors are connected to a high supply terminal (VCC), a first resistor (R1) disposed between the emitters of the transistors of said first differential pair, a second resistor (R2) disposed between the emitters of the transistors of said second differential pair, third and fourth resistors (RB1, RB2) disposed between the bases of the first and third transistors and of the second and fourth transistors, respectively, a voltage negative feedback means (A1, A2) disposed between the terminals of second resistor (R2) and the bases of the transistors of the first differential pair in order to fix the voltage across the second resistor to a predetermined input voltage (E1, E2).

**2.** The circuit of claim 1, characterized in that the negative feedback means includes operational amplifiers (A1, A2), each having a first input connected to a terminal of the second resistor, a second input forming an input terminal, and an output applied to the base of a transistor of the first differential pair.

**3.** The circuit of claim 2, characterized in that each operational amplifier is formed by a fifth NPN transistor (Q5) and a sixth PNP transistor (Q6), the base of the fifth transistor being connected to a terminal of the second resistor, the emitter of the fifth transistor being connected to the input terminal, the collector of the fifth transistor being connected to the high supply terminal through a current source (I5), the base of the sixth transistor being connected to the collector of the fifth transistor, the emitter of the sixth transistor being connected to the high supply terminal through a current source (I6) and to the base of a transistor of the first differential pair, and the collector of the sixth transistor being connected to the low supply terminal.

**4.** The circuit of claim 2, characterized in that an operational amplifier is formed by an NPN transistor (Q7, Q8) whose collector is connected to the high supply terminal through a current source (I7, I8) and to the base of a transistor of the first differential pair, having its emitter connected to a second input terminal and its base connected both to a first input terminal and to a terminal of the second resistor.

**5.** The circuit or claim 1, characterized in that the third and fourth resistors have a same value that is equal to half the value of the second resistor.

Fig 1

Fig 2

Fig 3

Fig 4

Fig 5

8

EP 0 587 509 B1

Fig 6

Fig 7

9